# EUROPEAN PATENT APPLICATION

(11) **EP 1 143 498 A2**
(43) Date of publication of application: **10.10.2001**
(21) Application number: 01303043.2
(22) Date of filing: 30.03.2001
(51) Int. Cl.: H01L 21/311, H01L 21/3213

(54) **Post etch photoresist and residue removal process**

(30) Priority: 02.04.2000 US 543373
(71) Applicant: Axcelis Technologies, Inc., Beverly, MA 01915 (US)
(72) Inventor: Waldfried, Carlo, Falls Church, Virginia 22042 (US); Bausum, Teresa Hope, Edgewater, Maryland 21037 (US); Berry, Ivan Louis III, Ellicott City, Maryland 21042 (US)
(74) Representative: West, Alan Harry

(57) **Abstract**

A plasma ashing stripping process for removing photoresist and post etch residues comprises the addition of CHF₃ to a plasma gas composition for forming reactive species in the plasma. The reactive species react with the photoresist and post etch residues to form volatile and water removable products. The addition of CHF₃ to either oxygen or oxygen-deficient plasmas results in a more aggressive ashing chemistry than the use of traditional fluorine gases, *i.e.,* NF₃ or CF₄ or C_{2,}F₆ or mixtures thereof. Significantly increased production of HF is observed enabling faster throughputs and the use of lower operating temperatures.

## Description

The present invention relates generally to a plasma ashing process for removing photoresist and post etch residues from a substrate. In particular, the invention is directed to the addition of CHF₃ to a plasma for generating reactive species that react with the photoresist and post etch residues to form volatile and/or water removable byproducts.

Ashing is a plasma stripping process by which residual photoresist and post etch residues are stripped or removed from a substrate upon exposure to the plasma. The ashing process generally occurs after an etching or implant process has been performed in which a photoresist material is used as a mask for etching a pattern into the underlying substrate or for selectively implanting ions into the exposed areas of the substrate. The remaining photoresist and any post etch residues on the wafer after the etch or implant process is complete must be removed prior to further processing for numerous reasons generally known to those skilled in the art. Typically, the plasmas used for the ashing process are generated from a gas mixture containing fluorine gas as one of the components. Fluorine gases, such as CF₄ or C₂F₆ and mixtures thereof, added to the ashing plasma are known to aid in the photoresist and polymer removal from post etch via and metal applications. Reactive species derived from the fluorine containing gas mixtures are generated in the plasma and these species diffuse or are directed to the substrate. The highly reactive species react with or oxidize residual photoresist and/or post etch residues to generate, among others, volatile byproducts such as carbon dioxide and water vapor which are then carried away in the plasma gas stream. Ashing is preferred to wet chemical removal because fewer process steps are involved, less handling of the substrates is required, chemicals and chemical handling equipment are reduced, and ashing is more environmentally acceptable.

A problem with current plasma ashing processes is the removal efficiency of certain post etch residues with the above noted fluorine gases in the plasmas. Integrated circuits utilize conductive metals such as aluminum and copper to complete the electronic circuitry. Etching processes can result in the formation of metal containing post etch residues that are very difficult to completely remove from the wafer surface during the subsequent ashing steps. The use of the traditional fluorine gases, *i*.*e*., C₂F₆ or CF₄ and mixtures thereof, are generally ineffective for removing these types of post etch residues and in those cases where the plasma is effective, longer exposure times are required. It is desirable to have a more aggressive ashing plasma chemistry that would completely and rapidly remove these types of post etch residues thereby lowering the costs for manufacturing an integrated circuit or the like.

One challenge for plasma ashing processes is to remove photoresist and post etch residues without affecting the etched or implanted pattern in the underlying substrate. Small deviations in the etched profiles can adversely impact device performance, yield and reliability of the final integrated circuit. Thus, it is desired that the more aggressive ashing chemistry have high selectivity with respect to the underlying substrate. For example, titanium nitride (TiN) is commonly used as the anti-reflective coating (ARC) for the back end metal layers. It is especially desirable for the ashing plasma chemistry to selectively remove the photoresist and post etch residues from the TiN surface or the like without etching into the substrate surface.

More advanced dry etch techniques have been developed with increased ash rates and ash selectivities. Oxygen-free plasmas, which typically contain forming gas (a mixture of 3% to 5% of hydrogen in nitrogen) and a fluorine gas, *i*.*e*., CF₄, are preferably utilized when low-k materials are present on the wafer. As such, it is desirable that the advantageously more aggressive plasma chemistry for removing photoresist and post etch residues be applicable to more than one plasma type.

The present invention is directed to ashing plasma processes for removing photoresist and/or post etch residues from a substrate. In particular, the present invention is directed to the addition of CHF₃ to the plasma to generate more reactive species in an amount effective for removing the photoresist and post etch residues from the substrate. Surprisingly, the Applicants have found that the addition of CHF₃ to oxygen or oxygen-deficient plasmas results in the generation of greater amounts of HF and reduced oxygen species than the use of traditional fluorine gases used for ashing photoresist and post etch residues from a substrate, *i*.*e*., C₂F₆ or CF₄ and mixtures thereof. This advantageously permits greater residue removal rates and higher selectivity.

The present invention overcomes the prior art problems associated with removal of photoresist and post etch residues from a substrate surface. The use of CHF₃ in the plasma cleanly and efficiently removes residual photoresist and post etch residues from the substrate that prior art process were ineffective. Unexpectedly, it has been found that the use of CHF₃ in the plasma is effective for removing metal containing post etch residues from the substrate surface while maintaining high selectivity for the underlying TiN layers.

In general, an oxygen deficient plasma gas composition for ashing photoresist and post etch residues from a substrate according to the present invention comprises a mixture of a forming gas from about 80 to 99 parts by volume; CHF₃ gas in an amount ranging from about 1 to 10 parts by volume and an oxygen source such as water vapor, or oxygen gas from about 0 to about 10 parts by volume. More preferably, the oxygen source is present from about 5 to 10 parts by volume. The forming gas is preferably from about 3 to 5% hydrogen in nitrogen.

An oxygen plasma gas composition for ashing photoresist and post etch residues from a substrate according to the present invention comprises oxygen gas in an amount ranging from about 50 to 70 parts about by volume; forming gas in an amount ranging from about 25 to 50 parts by volume; and CHF₃ gas in an amount ranging from 1 to 10 parts by volume. The forming gas is preferably from about 3 to 5% hydrogen in nitrogen.

These and other advantages and features of the invention will become better understood from the following detailed description of the invention in conjunction with the accompanying drawings, in which
Figure 1 depicts the components of a typical plasma asher device suitable for performing the ashing processes according the present invention;
Figure 2A are scanning electron microscopy micrographs of a via feature after a post etch ashing process using CF₄ as one of the plasma gas components;
Figure 2B are scanning electron microscopy micrographs of a via feature after a post etch ashing process according to the present invention using CHF₃ as one of the plasma gas components;
Figure 3 is a graph showing overlays of a residual gas analyses for four different plasma gas compositions and the corresponding oxygen plasmas thereof;
Figure 4A is a graph showing residual gas analyses for a CF₄ plasma gas composition and the corresponding oxygen free plasma thereof;
Figure 4B is a graph showing residual gas analyses for a CHF₃ plasma gas composition and the corresponding oxygen free plasma thereof;
Figure 5A is graph showing residual gas analyses for an oxygen free plasma according to the invention wherein the ratio of CHF₃ to the other components of the plasma gas composition is varied; and
Figure 5B is graph showing residual gas analyses for an oxygen free plasma wherein the ratio of CF₄ to the other components of the plasma gas composition is varied;

The present invention is directed to an ashing plasma process for removing photoresist and/or post etch residues from a substrate. In particular, the present invention is directed to the addition of CHF₃ to the plasma to generate more reactive species in an amount effective for removing the photoresist and post etch residues from the substrate. Surprisingly, the Applicants have found that the addition of CHF₃ to oxygen or oxygen-deficient plasmas for ashing photoresist and post etch residues results in a more aggressive and efficient ashing chemistry than the use of traditional fluorine gases, *i*.*e*., C₂F₆ or CF₄ and mixtures thereof.

The particular components of the plasma gas are selected by their ability to form a gas and a plasma at plasma forming conditions and will be apparent to those skilled in the art in view of this disclosure. The present invention is directed to the addition of CHF₃ to the plasma. Preferably, the components of the plasma including CHF₃ are combined and added to the plasma asher as a gas. The plasma gas containing CHF₃ primarily reacts with carbon and other atoms in the photoresist compounds and/or post etch residues to form volatile compounds and/or water removable compounds at conditions present in a plasma reaction chamber. Moreover, the plasma containing CHF₃ produces reactive species for efficiently removing those traditionally hard to remove post etch residues that contain aluminum or other metals embedded in the residue.

A typical oxygen plasma gas composition is a mixture of an oxygen gas, a hydrogen bearing gas and fluorine gases consisting of a selected one of tetrafluoromethane (CF₄), nitrogen trifluoride (NF₃) and hexafluoroethane (C₂F₆) and mixtures thereof. According to the present invention, CHF₃ added to these types of plasma gas compositions has been found to generate additional reactive species when ignited by the plasma that are more reactive and produce greater amounts of HF and F than the use of CF₄ or NF₃ plasmas. Moreover, it has been found that the use of CHF₃ as the only source of fluorine in oxygen or oxygen free plasmas results in more aggressive ashing plasma than the use of CF₄ or NF₃ and mixtures thereof.

Selectivity is defined as the relative removal rate of photoresist and/or post etch residues compared to the underlying layer. It is preferred to have a selectivity of at least 10:1 wherein the photoresist and/or post etch residues etch 10 times faster than the underlying substrate or material. More preferably, the etch selectivity is much greater than 10:1.

Preferably, the fluorine compounds in the oxygen containing plasma are less than about 10 percent of the total volume of the composition to maximize etch selectivity. It has been found that when the fluorine bearing compounds are greater than about 10 percent by volume, polymerization of the photoresist byproducts can occur making the polymerized photoresist more difficult to remove. CHF₃ can be added to the oxygen plasma gas composition as the sole source of fluorine or as a mixture of other fluorine gases, *i*.*e*., CF₄ or NF₃ or C₂F₆ or mixtures thereof.

The hydrogen bearing compounds include those compounds that contain hydrogen, for example, hydrocarbons, hydrofluorocarbons, hydrogen gas or hydrogen gas mixtures. The hydrogen bearing compounds used are ones that generate sufficient reactive species to increase selectivity of the stripping process.

Preferred hydrogen precursor gases are those that exist in a gaseous state and release hydrogen to form reactive hydrogen species such as free radical or hydrogen ions under plasma forming conditions. The gas may be a hydrocarbon that is unsubstituted or may be partially substituted with a halogen such as bromine, chlorine or fluorine, or with oxygen, nitrogen, hydroxyl and amine groups. Preferably, the hydrocarbon has at least one hydrogen and from one to twelve carbon atoms, and more preferably has from three to ten carbon atoms. Examples of suitable hydrogen bearing gases include methane, ethane ammonia, water and propane.

Preferred hydrogen gas mixtures are those gases that contain hydrogen gas and an inert gas. Examples of the inert gas include argon, nitrogen, neon, helium or the like. Especially preferred hydrogen gas mixtures are so-called forming gases which consist essentially of hydrogen gas and nitrogen gas. Particularly preferable for use in the present invention is a forming gas wherein the hydrogen gas ranges in an amount from about 3 to about 5 percent by volume of the total forming gas composition due to safety considerations.

Preferred oxygen plasma gas compositions for ashing photoresist and post etch residues from a substrate according to the present invention comprises oxygen gas in an amount ranging from about 50 to 70 parts about by volume, forming gas (H₂N₂) in an amount ranging from about 25 to 50 parts by volume, and CHF₃ gas in an amount ranging from 1 to 10 parts by volume. The forming gas is preferably from about 3 to 5% hydrogen in nitrogen.

The reactive species generated by an oxygen plasma for gas compositions including CHF₃ as one of its components, as an example without intending to be limiting, is believed to be presented in the following equations:

CHF₃ > CF₂ + HF

CF₂ + OH > CF₂O + H

CF₂ + O > CFO* + F

CFO* + O > CO₂ + F

A typical oxygen-deficient plasma gas composition is a mixture of a hydrogen bearing gas, a fluorine bearing gas such as tetrafluoromethane (CF₄), hexafluoroethane (C₂F₆) or nitrogen trifluoride (NF₃) and a small amount of an oxygen source such as water vapor, or oxygen gas. Other oxygen sources will be apparent to those skilled in the art in view of this disclosure. According to the present invention, CHF₃ added to oxygen deficient plasma gas compositions has been found to generate additional reactive species when ignited by the plasma that are more reactive and produce greater amounts of HF and F than the use of CF₄ plasmas. Moreover, the presence of a small amount of the oxygen source helps to prevent formation and deposition of particles onto the wafer during ashing that are believed to be carbon based species produced in the plasma.

The particular components of the oxygen deficient plasma gas are selected by their ability to form a gas and a plasma at plasma forming conditions. Preferably, the components are combined and added to the plasma asher as a gas. The oxygen deficient plasma gas primarily reacts with carbon and other atoms in the photoresist compounds and/or post etch residues to form volatile compounds and/or water removable compounds at conditions present in a plasma reaction chamber. Moreover, the oxygen deficient plasma reacts with those traditionally hard to remove post etch residues that contain silicon and/or other metals embedded in the residues.

A preferred oxygen deficient plasma gas composition according to the present invention, particularly when used with integrated circuits employing copper and low k dielectrics, is a mixture of a hydrogen bearing gas and CHF₃. Alternatively, mixtures of CHF₃ with other fluorine bearing compounds can be used to generate sufficient reactive species to increase the selectivity of the photoresist strip rate to the substrate. Fluorine bearing compounds suitable for use with CHF₃ include those compounds that generate fluorine reactive species when ignited by the plasma and will be apparent to one of ordinary skill in the art in view of this disclosure.

The hydrogen bearing compounds include those compounds that contain hydrogen, for example, hydrocarbons, hydrofluorocarbons, hydrogen gas or hydrogen gas mixtures. The hydrogen bearing compounds used are ones that generate sufficient reactive species to increase selectivity of the stripping process.

Preferred hydrogen precursor gases are those that exist in a gaseous state and release hydrogen to form reactive hydrogen species such as free radical or hydrogen ions under plasma forming conditions. The gas may be a hydrocarbon that is unsubstituted or may be partially substituted with a halogen such as bromine, chlorine or fluorine, or with oxygen, nitrogen, hydroxyl and amine groups. Preferably, the hydrocarbon has at least one hydrogen and from one to twelve carbon atoms, and more preferably has from three to ten carbon atoms. Examples of suitable hydrogen bearing gases include methane, ethane, ammonia and propane.

Preferred hydrogen gas mixtures are those gases that contain hydrogen gas and an inert gas. Examples of the inert gas include argon, nitrogen, neon, helium or the like. Especially preferred hydrogen gas mixtures are so-called forming gases which consist essentially of hydrogen gas and nitrogen gas. Particularly preferable for use in the present invention is a forming gas wherein the hydrogen gas ranges in an amount from about 3 to about 5 percent by volume of the total forming gas composition due to safety considerations.

Preferably, the total amount of fluorine bearing compounds, including CHF₃, is present in less than about 10 percent of the total volume of the gas composition to maximize etch selectivity. It has been found that when the fluorine bearing compounds are greater than about 10 percent by volume, polymerization of the photoresist byproducts can occur making the photoresist more difficult to remove. The mixing of the hydrogen bearing gas with CHF₃ gas results in the formation of hydrogen fluoride which is believed to be caused by scavenging of fluorine radicals by hydrogen. Hydrogen fluoride in the plasma is known to those skilled in the art to lower removal efficiency of traditional dielectrics, such as silicon dioxide.

Preferred oxygen deficient plasma gas compositions for ashing photoresist and post etch residues from a substrate according to the present invention comprises a mixture of a forming gas from about 80 to 99 parts by volume, CHF₃ gas in an amount ranging from about 1 to 10 parts by volume and an oxygen source such as water vapor, or oxygen gas in an amount greater than 0 to about 10 parts by volume. More preferably, the oxygen source is present from about 5 to about 10 parts by volume. The forming gas is preferably from about 3 to 5% hydrogen in nitrogen.

The invention is not intended to be limited to the use of CHF₃ in any particular oxygen deficient gas plasma or oxygen plasma. Other oxygen deficient or oxygen containing plasma compositions suitable for use in the present invention will be apparent to those skilled in the art in view of this disclosure.

Photoresists are generally organic photosensitive films used for transfer of images to an underlying substrate. The present invention is generally applicable to ashing those photoresists used in g-line, i-line, DUV, 193nm, and 157nm applications or the like. This includes, but is not limited to, novolaks, polyvinylphenols, acrylates, acetals, ketals, cyclic olefins or the like. Other suitable photoresist formulations will be apparent to those skilled in the art in view of this disclosure. The photoresist may be positive acting or negative acting depending on the photoresist chemistries and developers chosen.

The post etch residues are believed to be photoresist that have undergone a chemical change during earlier processing steps typically making the residue more resistant to the stripping plasma. The post etch residues include those residues known as sidewall polymer deposits. It is believed the chemical change occurs as a result of an earlier dielectric etching step by which the components of the plasma reactor lining or the wafer react with photoresist to form post etch residues or the chemical change may occur from the reaction of species generated during plasma processing.

Plasma asher devices particularly suitable for use in the present invention are downstream plasma ashers, such as for example, those microwave plasma ashers available under the trade name GEMINI ES and commercially available from Eaton Corporation. Portions of the microwave plasma asher are described in U.S. Patent Numbers 5,498,308 and 4,341,592, and PCT International Application No. WO/97/37055. The invention is not limited to any particular plasma asher in this or in the following embodiments.

Heating the wafer during ashing can increase the reaction rate between the plasma and the photoresist and/or post etch residues. In operation, wafers are typically heated from about 40°C to about 330°C depending on the materials used in the manufacture of the integrated circuit. However, it has been found that certain post etch residues are more easily removed at the lower temperatures. It is believed that certain post etch residues undergo a chemical change at the higher temperatures that makes these residues more resistant to stripping.

The removal rate can also be further optimized as is known to those skilled in the art. For example, the plasma chamber pressure can be changed from about 1 to about 10 torr, the power can be adjusted from about 500W to about 2000W and the total gas flow rates can be adjusted from about 500sccm to about 9000sccm. More preferably, the total gas flow rate is about 3000 sccm wherein CHF₃ flows at a rate of at least 50 sccm. More preferably, the flow rate of CHF₃ in a 3000 sccm total gas flow rate is about 150 sccm.

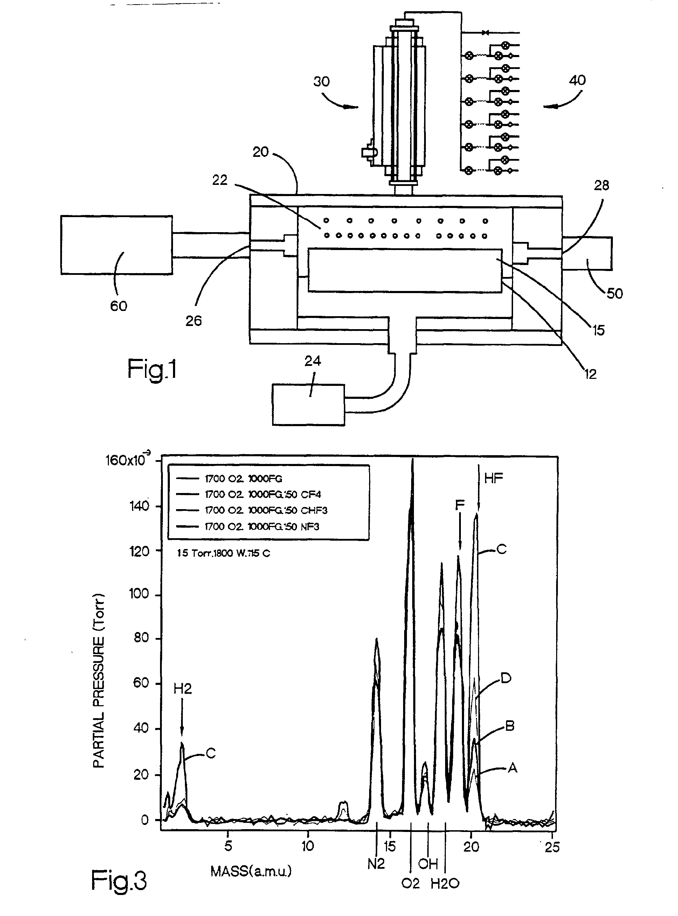

Turning now to the drawings and in particular Figure 1, a plasma asher device 10 is depicted. A reaction chamber 20 encloses a wafer 15 with photoresist and/or post etch residues thereon to be ashed. The wafer, as shown, is supported by a chuck 12 and is preferably heated to accelerate the reaction of the photoresist and/or post etch residues with the plasma. The pressure within the reaction chamber is reduced. Preferably, the pressure is maintained between about 1 torr to about 5 torr. More preferably, the pressure is maintained from about 1 torr to about 3 torr. A plasma generating system 30 is connected to the reaction chamber 20 to provide a plasma to the interior of the chamber 20. A gas box 40 controls the flow of gases into the plasma generating system. Once inside the plasma generating system, the gases (not shown) are exposed to an excitable energy source. For example, microwave energy can be generated by a magnetron to ionize the gases and form a plasma. Plasma exits the plasma generating system 30 and enters the reaction chamber 20 where it passes through a series of baffles 22 which spread the plasma more uniformly within the chamber. The plasma then impacts the wafer 15, reacting with the photoresist and post etch residues on the wafer to form volatile products and/or water removable products. A vacuum pump 24 continuously removes plasma and the volatile products from the chamber 20 and maintains a constant flow of plasma over the surface of the wafer 15. Ports 26 and 28 can be used to analyze the plasma and the reaction of the plasma with photoresist and post etch residues on the wafer. A spectrometer 50, a residual gas analyzer 60 or other analytical device may be mounted to port 26 or 28 to monitor the gas or plasma chemistry within the chamber 20 during the wafer's exposure to the plasma. The vacuum is then released and the processed wafers are removed from the reaction chamber. Optionally, a deionized water rinse process is then used to remove any remaining residue on the ashed wafer.

The following Example illustrate the invention.

### EXAMPLE 1

As illustrated by this example, a significant advantage of the preferred use of CHF₃ according to the invention in an oxygen plasma ashing process is the improvement in removal efficiency of photoresist and post etch residues from the substrate. Prior ashing processes are unable to completely remove the post etch residues present on the substrate after etching or require a long exposure time. Thus, the present invention reduces throughput times. This is a significant commercial advantage.

Via patterns were etched onto multiple silicon wafers having an oxide stack by a LAM 590 etcher using standard etching processes. After the etching process was complete, residual photoresist and post etch residues remained on the wafer. The photoresist used to pattern the vias was OCG 505 photoresist. The wafers were ashed using a Fusion Gemini ES Plasma Asher available from Eaton Corporation. Processing conditions are set forth in table I for each plasma ashing process. The forming gas consisted of a 5% hydrogen in nitrogen gas mixture (H₂N₂). Each process included an identical 10 minute deionized water rinsing process.

**Table IA:**

| CF₄ | | | | | | | |
|---|---|---|---|---|---|---|---|
| Step | Time (sec.) | Pressure (torr) | Temp (°C) | Power (W) | O₂ (sccm) | N₂H₂ (sccm) | CF₄ (sccm) |
| 1 | 0 | 1.0 | 140 | 1500 | 1160 | 720 | 150 |
| 2 | 120 | 1.0 | 140 | 1500 | 1160 | 720 | 150 |
| 3 | 20 | 1.0 | 140 | 1500 | 1950 | off | 50 |

**Table 1B:**

| CHF₃ | | | | | | | |
|---|---|---|---|---|---|---|---|
| Step | Time (sec.) | Pressure (torr) | Temp (°C) | Power (W) | O₂ (sccm) | N₂H₂ (sccm) | CHF₃ (sccm) |
| 1 | 0 | 1.0 | 140 | 1500 | 1160 | 720 | 150 |
| 2 | 60 | 1.0 | 140 | 1500 | 1160 | 720 | 150 |

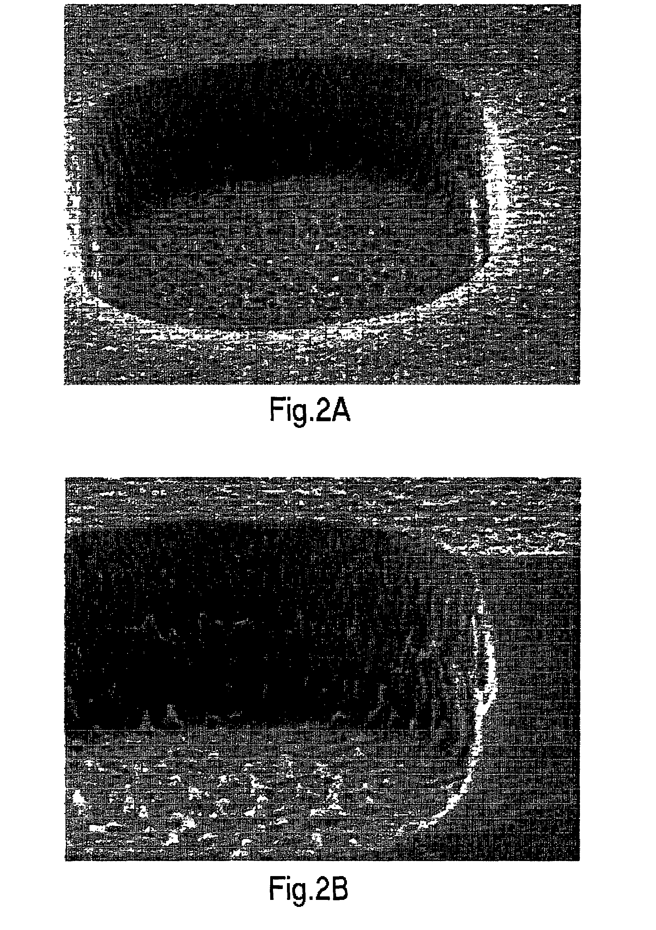

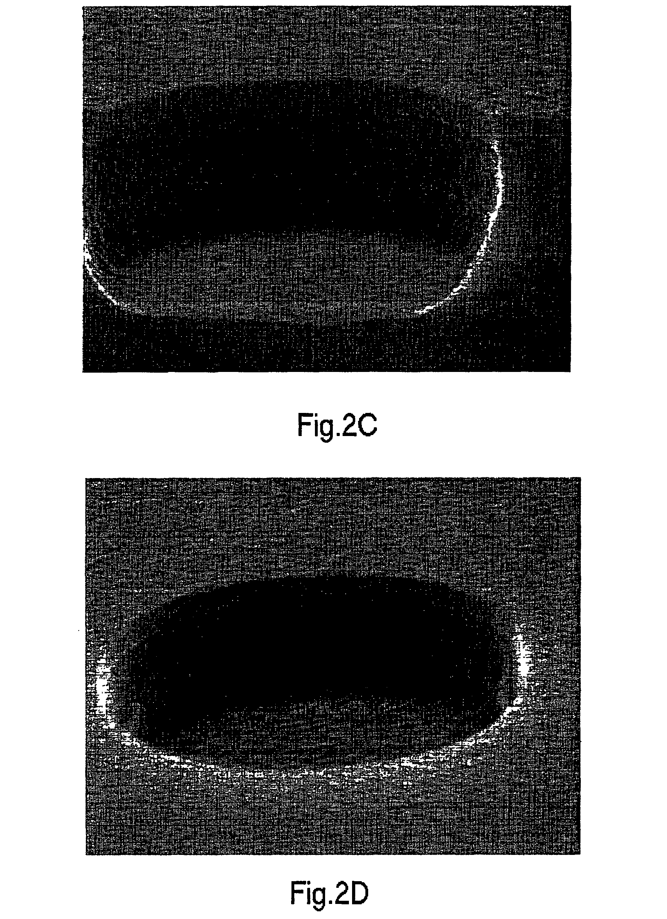

As shown in Figure 2 A, scanning electron microscopy of wafers ashed with CF₄ showed incomplete removal of the post etch residues whereas wafers ashed using CHF₃ (Figure 2B) resulted in complete removal of photoresist and post etch residues. Moreover, the time required to complete the ashing process for the CHF₃ plasma composition was 60 seconds compared to 120 seconds for the CF₄ process which did not result in complete removal of the post etch residues. An additional step that included a 20 second CF₄ plasma process with the forming gas off did not remove the post etch residues. Thus, the process time for the via level was reduced by a factor greater 2 for the CHF₃ plasma process relative to the CF₄ plasma process shown in Table Ib.

### EXAMPLE 2

In this example, residual gas analysis was performed in a chuck based down stream plasma asher. Residual gas analysis monitored the reactive species generated in the reaction chamber during ashing and during gas flow. The analysis did not include exposing a wafer having photoresist and post etch residues thereon to the plasma or gas flow. The results clearly demonstrate the greater reactivity of the process gases that includes CHF₃ as one of its components.

A Fusion Gemini ES Plasma Asher available from Eaton Corporation was fitted with a residual gas analyzer for studying the reactive species produced from various oxygen plasma gas compositions. A Stanford Research Model No. RGA 200 residual gas analyzer was connected to a port of the plasma asher reaction chamber. A 60 micron aperture was placed between the Analyzer and the reaction chamber to create a pressure reduction of about 10⁶. Additionally, a conflat UHV gate valve was placed between the Analyzer and the reaction chamber to protect the Analyzer from atmospheric pressure during wafer exchange. The plasma chamber power was set at 1800W with a chamber pressure of 1.5 torr and a temperature of 115°C. The forming gas consisted of a 3% hydrogen in nitrogen gas mixture (H₂N₂). Analysis was made with the power turned off, *i.e.,* with the process gases flowing and the asher power turned on, *i*.*e*., with the plasma on. Table II defines the process gas compositions analyzed.

**Table II**

| PLASMA | O₂ (sccm) | H₂N₂ (sccm) | CF₄ (sccm) | CHF₃ (seem) | NF₃ (sccm) |
|---|---|---|---|---|---|
| A | 1700 | 1000 | ---- | ---- | ---- |
| B | 1700 | 1000 | 150 | ---- | ---- |
| C | 1700 | 1000 | ---- | 150 | ---- |
| D | 1700 | 1000 | ---- | ---- | 150 |

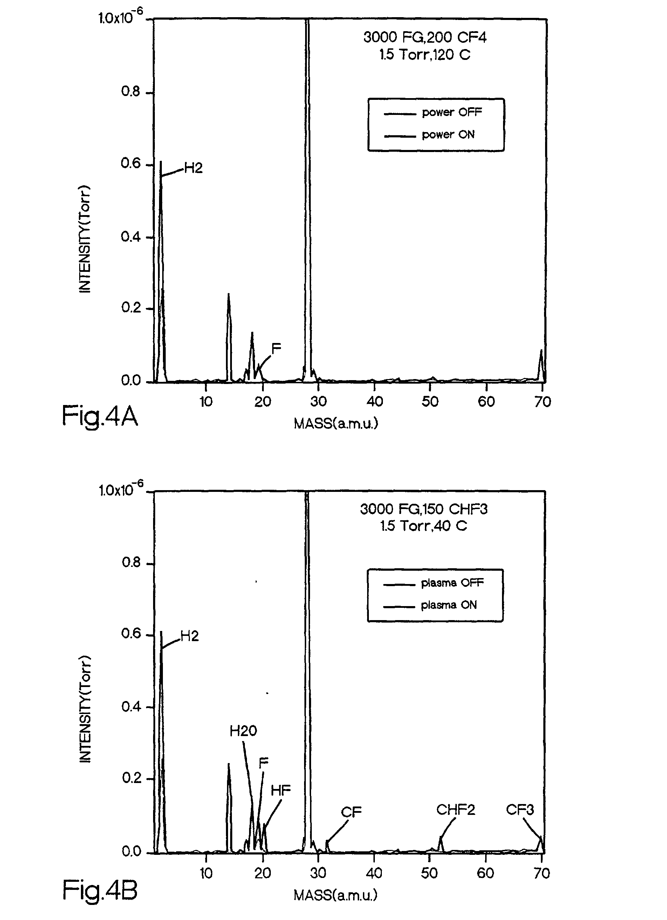

Figure 3 is a graphical illustration depicting the atomic species generated in the chamber for each of the gas compositions labeled respectively A, B, C, and D. The amount of hydrogen fluoride generated, as shown by the relative intensity at mass peak 19 in the graph, is a strong indicator of etching efficiency. Gas composition A, which contained no fluorine gas, is not expected to generate any HF. However, gas composition A did produce some intensity for other ions or fragments at mass peak 19 in the graph that is believed to represent the background noise due to water vapor and/or other contaminants typically present in the reaction chamber. HF is not produced by gas composition A. Surprisingly, gas composition C, which included CHF₃, generated the greatest amounts of HF. Gas compositions B and D which included NF₃ or CF₄ in the gas composition, did not generate as much HF as gas composition C, *i*.*e*., CHF₃, under similar conditions.

### EXAMPLE 3.

As illustrated by this example, the preferred use of CHF₃ according to the invention in an oxygen deficient plasma gas compositions efficiently produces greater amounts of HF than the addition of CF₄ to the same plasma under the same conditions.

Residual gas analysis was performed as in Example 2. Table III defines the process gas compositions analyzed and process conditions. The forming gas consisted of a 3% hydrogen in nitrogen gas mixture (H₂N₂). The plasma generated was oxygen free; no oxygen in the form of a gas or water vapor was added to the plasma.

**Table III**

| PLASMA | Power (W) | Pressure (torr) | Temp. (°C) | H₂N₂ (sccm) | CF₄(sccm) | CHF₃ (sccm) |
|---|---|---|---|---|---|---|
| E | 1800 | 1.5 | 120 | 3000 | 200 | ---- |
| F | 1800 | 1.5 | 40 | 3000 | ---- | 150 |

Figures 4A and 4B graphically illustrates the differences in species produced by plasma gas compositions E and F with and without the plasma turned on. Relative to the off position, with the gas compositions flowing into the reaction chamber, plasmas of composition E consumed H₂ and slightly increased the amount of F present. On the other hand, plasmas of composition F, which included CHF₃ as one of its components, efficiently consumed most or all of the H₂ present and significantly increased the production of HF and F. Moreover, it is apparent with plasma F that the peaks corresponding to CF₃, CHF₂ and CF present with the plasma off were consumed by the plasma when it was on. It is believed that consumption of these species further increased the production of HF.

### EXAMPLE 4.

As illustrated by this example, reactive species generated in a oxygen deficient plasma varied as a function of the ratio of the fluorine gas to the forming gas. Residual gas analysis was performed as in Example 2. Table IV defines the process gas compositions analyzed and process conditions. The forming gas consisted of a 3% hydrogen in nitrogen gas mixture (H₂N₂). The plasma generated was oxygen free; no oxygen in the form of a gas or water vapor was added to the plasma.

**Table IV**

| PLASMA | Power (W) | Pressure (torr) | Temp. (°C) | H₂N₂ (sccm) | CF₄ (sccm) | CHF₃ (sccm) |
|---|---|---|---|---|---|---|
| G | 1800 | 1.5 | 40 | 3000 | variable 0-200 | ---- |
| H | 1800 | 1.5 | 40 | 3000 | ---- | variable 0-150 |

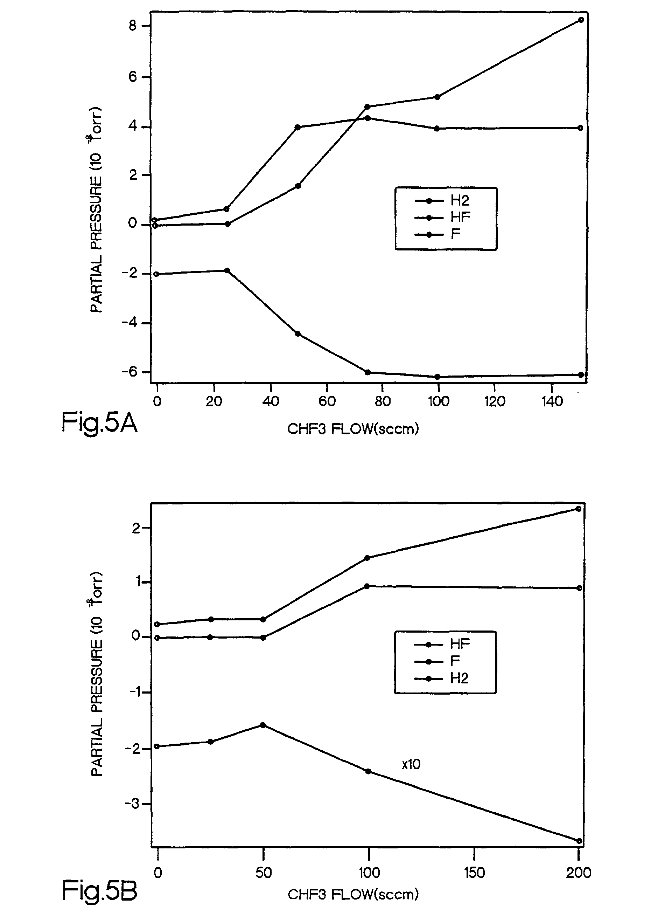

Figures 5A and 5B graphically illustrate the differences in results corresponding to the species generated by the respective plasmas produced from the gas compositions labeled respectively as G and H. Increased production of HF and F with a corresponding decrease in H₂ is observed at gas flow rates greater than 50 sccm for both plasma compositions. However, the intensity of the increase is greater with plasma gas composition H, *i.e.,* CHF₃, indicating significantly greater production of HF and F. Accordingly, the use of CHF₃ in the plasma results in a more aggressive ashing chemistry than CF₄.

In view of the foregoing examples, it is clear that the CHF₃ plasma chemistry is more active and more aggressive than conventional CF₄ chemistry. While oxygen plasmas of either fluorine gas result in a consumption of hydrogen and the formation of NO, CO₂, F, and HF, the efficiencies of these reactions are greatly different. The CHF₃ containing oxygen plasmas have been found to enhance the formation of CO₂, F, and HF, and reduce the production of NO. In addition, it has been found that CHF₃ in an oxygen plasma undergoes chemical reactions in which CHF₃ is consumed and COF₂ and COF is formed. These reactive species are identified in the residual gas analysis by the loss of the CHF₃ characteristic signatures , *i.e.,* CF₃, and CHF₃, and the appearance of COF₂ and COF as the plasma is ignited. The use of CHF₃ in an oxygen plasma consumes a significant amount of oxygen, relative to the use of CF₄ or NF₃, which is needed to support the reactions to form the final products CO₂ and COF₂.

For oxygen-containing plasmas, the addition of CF₄, CHF₃, or NF₃, to the plasma increased the efficiency of hydrogen consumption over fluorine-free plasmas. This is different for oxygen-deficient or oxygen free plasmas in which hydrogen is consumed significantly more efficiently with CHF₃ plasmas as compared to CF₄ plasmas. The use of CHF₃ in either oxygen-containing plasmas and the oxygen deficient plasmas, resulted in a significant increase in the generation of atomic fluorine (F) and hydrofluoric acid (HF). The residual gas analysis studies confirms that CHF₃ plasmas generate greater amounts of F and HF than the use of CF₄ or NF₃ plasmas. As a result, the use of CHF₃ in different types of plasmas surprisingly results in an aggressive ashing process that more efficiently removes substantially all of the photoresist and post etch residues from the substrate surface.

## Claims

1. A plasma ashing process for removing photoresist and post etch residues from a semiconductor substrate (15) comprising:
(a). placing at least one substrate (15) having photoresist and/or post etch residues thereon into a reaction chamber (20);
(b). forming reactive species by adding a plasma gas composition including CHF₃ as one of the components of the gas composition to a plasma; and
(c). removing the photoresist and/or the etch residues including sidewall polymer depositions by exposing the surface of the substrate (15) to said reactive species.

2. A process according to claim 1, wherein CHF₃ is the only source of fluorine in the plasma gas composition.

3. A process according to claim 1 or claim 2, further comprising step (d) wherein the substrate (15) is rinsed with deionized water.

4. A process according to any one of claims 1 to 3, wherein the hydrogen bearing gas is selected from hydrocarbons, hydrofluorocarbons, hydrogen gas and hydrogen gas mixtures.

5. A process according to claim 4, wherein the hydrogen gas mixture comprises an inert gas and hydrogen wherein the hydrogen is in an amount from 3 to 5 percent by volume of the gas mixture.

6. A process according to any one of claims 1 to 5, wherein CHF₃ and any other fluorine source are less than 10 percent by volume of the total plasma gas composition.

7. A process according to any one of claims 1 to 6, wherein the etching selectivity of the plasma between the photoresist and/or post etch residues, and the substrate is greater than 10 to 1.

8. A process according to any one of claims 1 to 7, wherein the plasma gas composition further comprises oxygen gas.

9. A process according to any one of claims 1 to 8, wherein CHF₃ flows into the reaction chamber 20 in an amount effective for removing metal-containing post etch residues.

10. A process according to any one of claims 1 to 9, wherein the ratio of CHF₃ to non-fluorine containing gases is at least 1 : 60.

11. An oxygen deficient plasma ashing process for a downstream plasma ashing device which includes flowing a plasma gas composition of a hydrogen bearing gas, an oxygen source and a CF₄ and/or C₂F₆ and/or NF₃ gas into a reaction chamber (20) and generating a plasma therein to form reactive species to react with photoresist and post etch residues on a substrate (15), **characterised by** flowing CHF₃ gas into the reaction chamber (20) in an amount effective to remove substantially all of the photoresist and post etch residues from the substrate.

12. A process according to claim 11, wherein CHF₃ flows into the reaction chamber at a gas flow rate of 50 to 500 sccm.

13. A process according to claim 11 or claim 12, wherein CHF₃ is the only source of an atomic fluorine species.

14. A process according to any one of claims 11 to 13, wherein CHF₃ in the plasma generates HF in an amount effective to remove photoresist and post etch residues.

15. A process according to any one of claims 11 to 14, wherein the oxygen source is selected from water vapor and oxygen gas.

16. An oxygen plasma ashing process for a downstream plasma ashing device which includes flowing a plasma gas composition of an oxygen gas, a hydrogen bearing gas and a CF₄ and/or C₂F₆ and/or NF₃ gas into a reaction chamber (20) and generating a plasma therein to remove photoresist and post etch residues from a substrate (15), **characterised by** flowing CHF₃ gas into the reaction chamber (20) in an amount effective to remove substantially all of the photoresist and post etch residues from the substrate (15).

17. A process according to claim 16, wherein CHF₃ flows into the reaction chamber (20) at a gas flow rate of 50 to 200 sccm.

18. A process according to claim 16 or claim 17, wherein CHF₃ is the only source of an atomic fluorine species.

19. A process according to any one of claims 16 to 18, wherein CHF₃ in the plasma generates HF in an amount effective to remove photoresist and post etch residues.

20. A plasma ashing process for removing photoresist and post etch residues from a semiconductor substrate (15) comprising:
(a). placing at least one substrate (15) having photoresist and/or post etch residues thereon into a reaction chamber (22);
(b). forming reactive species by adding a plasma gas composition consisting essentially of a forming gas, CHF₃ and oxygen to a plasma; and
(c). removing the photoresist and/or the etch residues including sidewall polymer depositions by exposing the surface of the substrate (15) to the reactive species and forming selected volatile compounds, water removable compounds and mixtures thereof.

21. A process according to claim 20, wherein CHF₃ gas is less than about 10 percent by volume of the total plasma gas composition.

22. A process according to claim 20 or claim 21, wherein the plasma gas composition further comprises one of CF₄ and C₂F₆ and mixtures thereof, and the total fluorine gases are less than about 10 percent by volume of the total plasma gas composition.

23. A process according to any one of claims 20 to 22, wherein the forming gas comprises hydrogen gas in an amount of 3 to 5 percent by volume of the forming gas.

24. An ashing plasma gas composition for removing photoresist and post etch residues from a substrate (15) comprising:
(a). forming gas comprising 80 to 99 parts by volume wherein the forming gas comprises 3 to 5% hydrogen in nitrogen;
(b). CHF₃ gas in an amount of 1 to 10 parts by volume; and
(c). an oxygen source in an amount greater than 0 to 10 parts by volume, the oxygen source being selected from water vapor and oxygen gas.

25. An ashing plasma gas composition for removing photoresist and post etch residues from a substrate (15) comprising:
(a). oxygen gas in an amount of 50 to 70 parts by volume;
(b). forming gas in an amount of 25 to 50 parts by volume wherein the forming gas comprises 3 to 5% hydrogen in nitrogen; and
(c). CHF₃ gas in an amount of 1 to 10 parts by volume.
